(19) Europäisches Patentamt
European Patent Office
Office européen des brevets

(11) **EP 2 256 505 A2**

(12) **EUROPEAN PATENT APPLICATION**

(43) Date of publication:
**01.12.2010 Bulletin 2010/48**

(51) Int Cl.:
***G01R 19/25*** (2006.01)

(21) Application number: **10163157.0**

(22) Date of filing: **18.05.2010**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO SE SI SK SM TR**<br>Designated Extension States:<br>**BA ME RS** | (72) Inventors:<br>• **Lakich, Daniel M.**<br>  **Walhalla, SC 29691 (US)**<br>• **Huang, Jiangyang**<br>  **Seneca, SC 29672 (US)** |
| (30) Priority: **27.05.2009 US 472602** | (74) Representative: **Hervouet, Sylvie et al**<br>**Feray Lenne Conseil**<br>**Le Centralis** |
| (71) Applicant: **Itron, Inc.**<br>**Liberty Lake, WA 99019 (US)** | **63, avenue du Général Leclerc**<br>**92340 Bourg-la-Reine (FR)** |

(54) **Voltage monitoring in an advanced metering infrastructure**

(57)     Disclosed are apparatus and methodology for monitoring voltage at individual utility meters in a distribution system together with voltage levels at a substation associated with the distribution system. Voltage measurements are made over a predetermined time interval and compared to plural sets of threshold values.

**EP 2 256 505 A2**

## Description

<u>FIELD OF THE INVENTION</u>

The present subject matter relates to electrical power transmission infrastructure. More particularly, the present subject matter relates to end of line voltage quality monitoring in Advanced Metering Infrastructure (AMI) systems.

<u>BACKGROUND OF THE INVENTION</u>

There can be many causes for residential voltage quality to suffer. Some disturbances are very short "flicker" type events and others are caused by misapplication or failure of distribution equipment. Some examples are worn out recloser contacts, misapplication of power factor correction, or a malfunctioning regulator.

U.S. Patent No. 6,954,814 to <u>Leach</u> is directed to a method and system for providing notification of utility status to a remote location.

U.S. Patent No. 6,792,364 to Jonker et al. relates to a system and method of power quality detection, monitoring, reporting, and communication in a revenue accuracy electrical power meter.

U.S. Patent Nos. 6,675,071 and 6,429,785 both to Griffin et al. disclose voltage handling features for capturing waveforms and related data including power quality when line voltage magnitude exceeds certain thresholds.

U.S. Patent Application Publication 2003/0009401 to Ellis discloses a utility application including a power quality module that captures electrical disturbances that fall outside industry-specified tolerances.

U.S. Patent Application Publication 2002/0077729 to Anderson discloses a utility meter that implements a voltage threshold routine to determine whether a voltage level falls outside a predetermined window.

U.S. Patent Application Publication 2005/0132115 to Leach discloses an AMR system with utility signals including tamper detection, voltage monitoring, outage notification, and reconnect/disconnect monitoring.

U.S. Patent No. 6,778,920 to Balch et al. discloses methods and apparatus for metering energy consumption that monitor voltage sags/swells, and for performing some predetermined task upon detection of voltage changes.

While various implementations of voltage monitoring systems have been developed, no design has emerged that generally encompasses all of the desired characteristics as hereafter presented in accordance with the subject technology.

<u>SUMMARY OF THE INVENTION</u>

In view of the recognized features encountered in the prior art and addressed by the present subject matter, improved apparatus and methodology are provided for continuously monitor power quality at a substation, while simultaneously monitoring average voltage at every residential meter serviced by such substation.

In an exemplary configuration, the average voltage at any residential meter is monitored and an alarm condition is determined if a predetermined maximum or minimum threshold is exceeded.

In one of its simpler forms, a software application is configured to correlate voltage events at residential meters with coincident voltage quality data from the substation monitoring equipment, so as to preferably narrow down locations and scope of any outage or other line voltage related issues.

In accordance with aspects of certain embodiments of the present subject matter, methodologies are provided to calculate voltage demand and extreme values during given time intervals.

In accordance with certain aspects of other embodiments of the present subject matter, methodologies have been developed to define different threshold values to obtain system snapshots versus communicating alarm signals and related information over a communications network.

One present exemplary embodiment relates to a method for monitoring voltage in an electrical power transmission infrastructure. Such exemplary method preferably may comprise establishing a plurality of threshold values; performing a plurality of instantaneous voltage measurements at a utility consumer meter; determining for a measurement period an average voltage value from the plurality of instantaneous voltage measurements performed at the utility consumer meter; and comparing the average voltage value to the plurality of threshold values to determine if the average voltage value respectively falls outside of any of the plurality of threshold values.

In such exemplary methodology, preferably such plurality of threshold values may comprise threshold value *Vmax1* and threshold value *Vmin1;* and the method may further comprise triggering a voltage threshold event if the average voltage value is greater than threshold value *Vmax1* or if the average voltage value is less than threshold value *Vmin1.*

Alternatively, such exemplary method may further comprise performing a plurality of instantaneous voltage measurement *Vinst$_{(n)}$* every time interval *t*; converting each respective instantaneous voltage measurement *Vinst$_{(n)}$* into an energy equivalent value *Vh$_{(n)}$* according to the following:

$$Vh_{(n)} = \frac{Vinst_{(n)}}{T};$$

and
determining the average voltage value *Vdemand* according to the following:

$$Vdemand = \frac{\sum_{n=1}^{I} Vh_{(n)}}{I},$$

wherein T is equal to the number of time intervals !n one hour and / is equal to the number of time intervals *t* in a measurement period.

In still further present exemplary embodiments of the foregoing, such method may comprise monitoring the voltage quality at a substation meter located upstream of the utility consumer meter to generate voltage quality data for the electrical power transmission infrastructure; triggering a voltage threshold event if the average voltage value respectively falls outside one of the plurality of threshold values; and correlating the voltage threshold event of the utility consumer meter with the voltage quality data for the electrical power transmission infrastructure.

In other present exemplary alternatives, such method may further comprise determining a minimum voltage value *Vlow* for a measurement period at the utility consumer meter; and determining a maximum voltage value *Vhigh* for the measurement period at the utility consumer meter. In such exemplary embodiment variation, such method may further include determining the minimum voltage value *Vlow* by setting an initial value of *Vlow* to a nominal voltage value; comparing each instantaneous voltage measurement to *Vlow*; and setting *Vlow* equal to the instantaneous voltage measurement if the instantaneous voltage measurement is less than *Vlow*; while such method may include determining the maximum voltage value *Vhigh* by setting an initial value of *Vhigh* to a nominal voltage value; comparing each instantaneous voltage measurement to *Vhigh*; and setting *Vhigh* equal to the instantaneous voltage measurement if the instantaneous voltage measurement is greater than *Vhigh.*

In other present exemplary embodiments, present methodology may further include triggering a voltage threshold event if the average voltage value respectively falls outside one of the plurality of threshold values. Still further such an exemplary voltage threshold event may include performing a data snapshot for a measurement period. Such exemplary data snapshot may include the average voltage value for a measurement period, a minimum voltage value *Vlow* for the measurement period, a maximum voltage value *Vhigh* for the measurement period, and the date and time of occurrence of the voltage threshold event. Still further, such method may include communicating the data snapshot over a communications network.

In another present exemplary alternative of the foregoing method, the plurality of threshold values may comprise threshold value *Vmax1,* threshold value *Vmin1,* threshold value *Vmax2* and threshold value *Vmin2;* and such method may further include triggering a first voltage threshold event if the average voltage value is greater than *Vmax1* or is less than *Vmin1*; and triggering a second voltage threshold event if the average voltage value is greater than *Vmax2* or is less than *Vmin2.* In the foregoing variation, preferably such second voltage threshold event is different from the first voltage threshold event. Further in such variation, triggering the first voltage threshold event may include performing a data snapshot of the measurement period; and triggering the second voltage threshold event may include communicating an alarm signal over a communications network.

It is to be understood by those of ordinary skill in the art that the present subject matter is fully intended as encompassing corresponding systems for performing methodologies described and disclosed herein.

Another present exemplary embodiment of present methodology relates to a method for monitoring voltage in an electrical power transmission infrastructure associated with a communications network. Such a present methodology preferably comprises establishing a plurality of threshold values *Vmax1, Vmin1, Vmax2,* and *Vmin2;* performing a plurality of instantaneous voltage measurements *Vinst* at a utility consumer meter for a measurement period; determining an average voltage value for the measurement period at the utility consumer meter from the plurality of instantaneous voltage measurements; determining a minimum voltage value *Vlow* by setting an initial value of *Vlow* to a nominal voltage value; comparing each instantaneous voltage measurement *Vinst* to *Vlow,* and setting *Vlow* equal to the instantaneous voltage measurement *Vinst* if the instantaneous voltage measurement *Vinst* is less than *Vlow;* determining a maximum voltage value *Vhigh* by setting an initial value of *Vhigh* to the nominal voltage value, comparing each the instantaneous voltage measurement *Vinst* to *Vhigh,* and setting *Vhigh* equal to the instantaneous voltage measurement *Vinst* if the instantaneous voltage measurement *Vinst* is greater than *Vhigh;* at the end of the measurement period, comparing the average voltage value respectively to each of the plurality of threshold values; triggering a first threshold event if the average voltage value is greater than *Vmax1* or less than *Vmin1,* the triggering of the first threshold event including logging an event in a history log stored at an associated utility consumer meter; and triggering a second threshold event if the average voltage value is greater than *Vmax2* or less than *Vmin2,* the triggering of the second threshold event including sending an exception alarm over the communications network.

In an exemplary variation of such present methodology, such method may further comprise performing an instantaneous voltage measurement *Vinst* every second, converting each instantaneous voltage measurement *Vinst into* an energy equivalent value *Vh* according to the following:

$$Vh = \frac{Vinst}{3600};$$

and
determining the average voltage value *Vdemand* according to the following:

$$Vdemand = \frac{\sum_{n=1}^{I} Vh_{(n)}}{I},$$

wherein I is equal to the number of seconds in such measurement period.

In certain present exemplary embodiments of the foregoing methodology, the nominal voltage value is preferably equal to about 240 V.

In other present exemplary variations, such method may further comprise monitoring voltage quality at a substation meter located upstream of the utility consumer meter to generate voltage quality data for the associated electrical power transmission infrastructure; correlating such first voltage threshold event of the utility consumer meter with the voltage quality data for the associated electrical power transmission infrastructure; and providing the communications network as an RF LAN communications network.

Additional objects and advantages of the present subject matter are set forth in, or will be apparent to, those of ordinary skill in the art from the detailed description herein. Also, it should be further appreciated that modifications and variations to the specifically illustrated, referred and discussed features, elements, and steps hereof may be practiced in various embodiments and uses of the present subject matter without departing from the spirit and scope of the subject matter. Variations may include, but are not limited to, substitution of equivalent means, features, or steps for those illustrated, referenced, or discussed, and the functional, operational, or positional reversal of various parts, features, steps, or the like.

Still further, it is to be understood that different embodiments, as well as different presently preferred embodiments, of the present subject matter may include various combinations or configurations of presently disclosed features, steps, or elements, or their equivalents (including combinations of features, parts, or steps or configurations thereof not expressly shown in the figures or stated in the detailed description of such figures). Additional embodiments of the present subject matter, not necessarily expressed in the summarized section, may include and incorporate various combinations of aspects of features, components, or steps referenced in the summarized objects above, and/or other features, components, or steps as otherwise discussed in this application.

Those of ordinary skill in the art will better appreciate the features and aspects of such embodiments, and others, upon review of the remainder of the specification.

## BRIEF DESCRIPTION OF THE DRAWINGS

A full and enabling disclosure of the present subject matter, including the best mode thereof, directed to one of ordinary skill in the art, is set forth in the specification, which makes reference to the appended figures, in which:

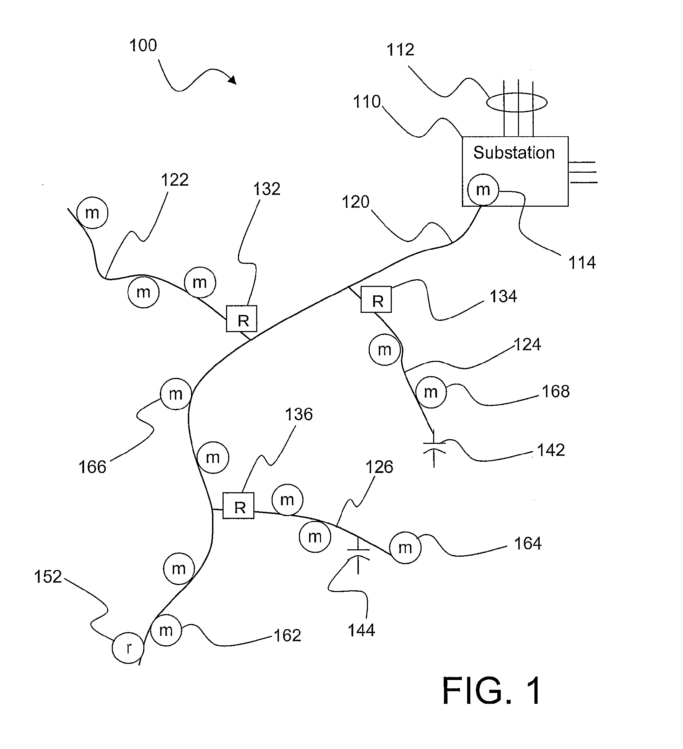

Figure 1 schematically illustrates a portion of an exemplary power distribution system from a substation to a neighborhood.

Repeat use of reference characters throughout the present specification and appended drawings is intended to represent same or analogous features, elements, or steps of the present subject matter.

## DETAILED DESCRIPTION OF THE PREFERRED EMBODIMENTS

As discussed in the Summary of the Invention section, the present subject matter is particularly concerned with improved apparatus and methodology for continuously monitoring power quality at a substation, while simultaneously monitoring average voltage at every residential meter serviced by the substation.

Selected combinations of aspects of the disclosed technology correspond to a plurality of different embodiments of the present subject matter. It should be noted that each of the exemplary embodiments presented and discussed herein should not insinuate limitations of the present subject matter. Features or steps illustrated or described as part of one embodiment may be used in combination with aspects of another embodiment to yield yet further embodiments. Additionally, certain features may be interchanged with similar devices or features not expressly mentioned which perform the same or similar function.

Reference will now be made in detail to the presently preferred embodiments of the subject voltage monitoring system and methodologies. Referring now to the drawings, Figure 1 schematically illustrates a portion of representative power distribution system generally 100 from a substation 110 to a neighborhood including a number of residential buildings as well as other electrical utility consumers. Representative substation 110 receives power via transmission lines 112 from one or more upstream sources (not separately illustrated). It should also be appreciated that monitoring and control facilities may also be provided upstream of substation 112, and it is to such monitoring and control facilities that data per the presently disclosed subject matter may be sent for analysis and control of downstream distribution components.

Power distribution system generally 100 may include a main line 120 extending to a neighborhood and may include a number of branch lines 122, 124, 126 that may be selectively coupled to main line 120 by way of a corresponding plurality of respective recloser type breakers 132, 134, 136.

A representative polyphase meter generally 114 with voltage quality monitoring capabilities (or other dedicated power quality instrument) is used to measure and monitor the voltage at the substation distribution points or feeders. Polyphase meter 114 is used by the system to determine the quality of the voltage at the distribution source, and is coupled to a high bandwidth, always on, connection to a monitoring system (not separately illustrated). Power distribution system generally 100 may also include a number of switchable power factor (PF) correction devices generally 142, 144 as required depending on the loads coupled to, for example, branch lines 122, 126. In addition, line regulators such as regulator 152 may be provided as required.

Individual residences or other electrical utility consumers are supplied power by way of metrology devices representatively illustrated as meters 162, 164, 166, 168. In an exemplary embodiment, such meters 162, 164, 166, 168 may correspond, for example, to a CENTRON® utility meter manufactured by ITRON, the owners of the present subject matter.

CENTRON® metrology comprises a highly complex metering device used for residential and other consumer metrology purposes, and is configured to transmit messages to a central facility regarding various operational characteristics of the power distribution system and, more specifically, consumption by individual residential or other electrical power users connected to the distribution system. For purposes of the present subject matter, it is noted that the broadcast message from CENTRON® meters contains data representative of the measurement of instantaneous voltage at the meter. For a residential meter, the voltage measurement available is the 240v line-to-line voltage.

In accordance with present technology, the instantaneous voltage at the meter is measured over a predetermined time period and is converted to an energy equivalent. For example, in an exemplary configuration, instantaneous voltage may be measured for 1 second, and the value converted to energy by dividing by 3600, i.e., the number of seconds in an hour. In other embodiments, integer math may be employed in order to use very simple algorithms and yet maintain adequate resolution for the application.

In the instance that measurements are taken each second, the meter will derive volt-hours by dividing the instantaneous value by 3600 so that:

$$Vh = \frac{Vinst}{3600}$$

Where: *Vh* is volt-hours per second, *Vinst* is the instantaneous voltage from the metrology broadcast message, and 3600 is the number of seconds in one hour.

In accordance with present technology, each respective exemplary residential meter 162, 164, 166, 168 is configured to store energy data in a load profile. In the CENTRON® meter, Volthours is a quantity available for storage in the load profile. It is simply the accumulation of one (1) second Vh measurements for the duration of the load profile interval. At the end of the interval, Vdemand for the interval is calculated as follows:

$$Vdemand = \frac{\sum_{n=1}^{I} Vh}{I}$$

Where *Vdemand* is the average voltage over the interval and *I* is the number of seconds in the interval.

In accordance with present technology, calculating a *Vdemand* value allows comparison to thresholds for event logging and exception reporting to the system. During each interval, two voltage values are maintained, *Vlow* and *Vhigh*. Both *Vlow* and *Vhigh* will start the interval equal to the nominal voltage, for example, 240v. Each second *Vinst* will be compared to *Vlow* and *Vhigh*. If *Vinst* is less than *Vlow*, Vlow *will* be set equal to *Vinst*. Likewise if *Vinst* is greater than *Vhigh*, *Vhigh* will be set equal to *Vinst*. At the end of each interval the values *Vlow* and *Vhigh* will represent the low and high voltage extremes during the interval.

In accordance with one exemplary embodiment of the present technology, four (4) voltage demand thresholds may be configured, including two *Vmax* and two *Vmin* thresholds, and arranged in sets. One set (*Vmax1* and *Vmin1*) may be enabled and configured to log an event to the history log but not to send an exception alarm to the collection system. The other set (*Vmax2* and *Vmin2*) may be set to send an exception alarm to the collection system when an event occurs. At the end of each interval, when *Vdemand* is calculated, *Vdemand* is compared to each *Vmax* and *Vmin* value. If *Vdemand* is greater than *Vmax* or less than *Vmin*, a voltage threshold event is triggered.

In response to a threshold event, the meter will always store in a history log a data snapshot of information pertaining to the alarm condition. At a minimum, such data snapshot will contain the *Vdemand* value, *Vhigh*, *Vlow*, and the date and time of occurrence of the event. If enabled for the event per a particular embodiment, an exception alarm can be sent to the system immediately upon detection of the voltage threshold event.

Each voltage threshold value *(Vmax1, Vmax2, Vmin1, Vmin2)* may be independently configured to send an alarm message to the system. Overall, per one present exemplary embodiment, the intention is to allow a first set of thresholds to simply trigger a snapshot of data but not result in a data transmission over the RF LAN. A second set of thresholds could be configured to send an alarm message to the system to indicate a condition that warrants immediate attention. Preferably, only the current data snapshot would be sent to the system per such implementation of the present subject matter.

Generally, no attempt to snapshot energy data or load information during the alarm interval is necessary, as that information is available in the meter's interval data, already being sent to the system, or via "on demand" reads. All alarm data would be available via "on demand" reads issued from the system. Per the present subject matter, advantageously, the thresholds and report by exception minimize the amount of data that must be handled by the AMI RF LAN and the system software component.

While the present subject matter has been described in detail with respect to specific embodiments thereof, it will be appreciated that those skilled in the art, upon attaining an understanding of the foregoing may readily produce alterations to, variations of, and equivalents to such embodiments. For example, the present subject matter may be practiced with great variety in the number of meters, other than the four exemplary residential meters 162, 164, 166, 168 discussed herewith. Accordingly, the scope of the present disclosure is by way of example rather than by way of limitation, and the subject disclosure does not preclude inclusion of such modifications, variations and/or additions to the present subject matter as would be readily apparent to one of ordinary skill in the art.

**Claims**

1. A method for monitoring voltage in an electrical power transmission infrastructure, comprising:

   establishing a plurality of threshold values;
   performing a plurality of instantaneous voltage measurements at a utility consumer meter;
   determining for a measurement period an average voltage value from the plurality of instantaneous voltage measurements performed at the utility consumer meter; and
   comparing such average voltage value to the plurality of threshold values to determine if such average voltage value respectively falls outside of any of the plurality of threshold values.

2. The method of claim 1, wherein:

   the plurality of threshold values comprises threshold value *Vmax1* and threshold value *Vmin1;* and
   such method further comprises triggering a voltage threshold event if the average voltage value is greater than threshold value *Vmax1* or if the average voltage value is less than threshold value *Vmin1.*

3. The method of claim 1, wherein the method comprises:

   performing a plurality of instantaneous voltage measurement $Vinst_{(n)}$ every time interval $t$;
   converting each respective instantaneous voltage measurement $Vinst_{(n)}$ into an energy equivalent value $Vh_{(n)}$ according to the following:

   $$Vh_{(n)} = \frac{Vinst_{(n)}}{T} \, ;$$

   and
   determining the average voltage value *Vdemand* according to the following:

   $$Vdemand = \frac{\sum_{n=1}^{I} Vh_{(n)}}{I} \, ,$$ wherein $T$ is equal to the

   number of time intervals $t$ in one hour and $I$ is equal to the number of time intervals $t$ in a measurement period.

4. The method of claim 1, wherein the method comprises:

   monitoring the voltage quality at a substation meter located upstream of the utility consumer meter to generate voltage quality data for the electrical power transmission infrastructure;
   triggering a voltage threshold event if such average voltage value respectively falls outside one of the plurality of threshold values; and
   correlating such voltage threshold event of such utility consumer meter with such voltage quality data for the electrical power transmission infrastructure.

5. The method of claim 1, wherein the method comprises:

   determining a minimum voltage value *Vlow* for a measurement period at the utility consumer meter; and
   determining a maximum voltage value *Vhigh* for such measurement period at the utility consumer meter.

6. The method of claim 5, wherein the method further includes:

   determining such minimum voltage value *Vlow* by:

   setting an initial value of *Vlow* to a nominal voltage value;
comparing each instantaneous voltage measurement to *Vlow;* and
setting *Vlow* equal to such instantaneous voltage measurement if such instantaneous voltage measurement is less than *Vlow;* and

determining the maximum voltage value *Vhigh* by:

setting an initial value of *Vhigh* to a nominal voltage value;
comparing each instantaneous voltage measurement to *Vhigh;* and
setting *Vhigh* equal to such instantaneous voltage measurement if such instantaneous voltage measurement is greater than *Vhigh.*

7. The method of claim 1, wherein:

the method further includes triggering a voltage threshold event if the average voltage value respectively falls outside one of the plurality of threshold values;
the voltage threshold event includes performing a data snapshot for a measurement period; and
the data snapshot includes the average voltage value for a measurement period, a minimum voltage value *Vlow* for such measurement period, a maximum voltage value *Vhigh* for such measurement period, and the date and time of occurrence of such voltage threshold event.

8. The method of claim 1, wherein:

the method further includes triggering a voltage threshold event if the average voltage value respectively falls outside one of the plurality of threshold values;
the voltage threshold event includes performing a data snapshot for a measurement period; and
the method further includes communicating such data snapshot over a communications network.

9. The method of claim 1, wherein:

the plurality of threshold values comprises threshold value *Vmax1,* threshold value *Vmin1,* threshold value *Vmax2* and threshold value *Vmin2;* and
such method further includes triggering a first voltage threshold event if the average voltage value is greater than *Vmax1* or is less than *Vmin1;* and
triggering a second voltage threshold event if the average voltage value is greater than *Vmax2* or is less than *Vmin2;*
the second voltage threshold event is different from the first voltage threshold event;
triggering the first voltage threshold event includes performing a data snapshot of the measurement period; and
triggering the second voltage threshold event includes communicating an alarm signal over a communications network.

10. A system for monitoring voltage in an electrical power transmission infrastructure, said system comprising:

a utility consumer meter configured to perform a plurality of instantaneous voltage measurements;
a substation meter located upstream of said utility consumer meter, said substation meter configured to generate voltage quality data for the associated electrical power transmission infrastructure; and
a voltage monitoring center in communication with said utility consumer meter and said substation meter;
wherein said utility consumer meter is further configured to determine an average voltage value from said plurality of instantaneous voltage measurements for a measurement period, to compare said average voltage value to a plurality of threshold values, and to determine if said average voltage value respectively falls outside of any of said plurality of threshold values.

11. The system of claim 10, wherein:

said plurality of threshold values comprise a threshold value *Vmax1* and threshold value *Vmin1;* and
said utility consumer meter is further configured to trigger a voltage threshold event if said average voltage value is greater than threshold value *Vmax1* or if said average voltage value is less than threshold value *Vmin1.*

12. The system of claim 10, wherein said utility consumer meter is further configured to perform an instantaneous voltage measurement $Vinst_{(n)}$ every time interval $t$, to convert each said instantaneous voltage measurement $Vinst_{(n)}$ into an energy equivalent value $Vh_{(n)}$ according to the following:

$$Vh_{(n)} = \frac{Vinst_{(n)}}{T},$$

and

to determine said average voltage value *Vdemand* according to the following:

$$Vdemand = \frac{\sum_{n=1}^{I} Vh_{(n)}}{I},$$

wherein T is equal to the
number of time intervals *t* in one hour and *I* is equal to the number of said time intervals *t* in said measurement period.

13. The system of claim 10, wherein said utility consumer meter is further configured to trigger a voltage threshold event if said average voltage value exceeds one of said plurality of threshold values, said voltage monitoring center is further configured to correlate said voltage threshold event of said utility consumer meter with said voltage quality data for the associated electrical power transmission infrastructure.

14. The system of claim 10, wherein said utility consumer meter is further configured to determine a minimum voltage value *Vlow* and a maximum voltage *Vhigh* for said measurement period, and is further configured to determine said minimum voltage value *Vlow* by:

setting an initial value of *Vlow* to a nominal voltage value;
comparing each said instantaneous voltage measurement to *Vlow*; and
setting *Vlow* equal to said instantaneous voltage measurement if said instantaneous voltage measurement is less than *Vlow*.

15. The system of claim 10, wherein said utility consumer meter is further configured to determine a minimum voltage value *Vlow* and a maximum voltage *Vhigh* for said measurement period, and is further configured to determine said maximum voltage value *Vhigh* by:

setting an initial value of *Vhigh* to a nominal voltage value;
comparing each said instantaneous voltage measurement to *Vhigh;* and
setting *Vhigh* equal to said instantaneous voltage measurement if said instantaneous voltage measurement is greater than *Vhigh.*

16. The system of claim 10, wherein:

said plurality of threshold values comprises threshold value *Vmax1,* threshold value *Vmin1,* threshold value *Vmax2* and threshold value *Vmin2;*
said utility consumer meter is further configured to trigger a first voltage threshold event if said average voltage value is greater than *Vmax1* or is less than *Vmin1* and to trigger a second voltage threshold event if said average voltage value is greater than *Vmax2* or is less than *Vmin2;* and
said second voltage threshold event is different from said first voltage threshold event.

17. The system of claim 10, wherein:

said utility consumer meter is configured to trigger a voltage threshold event if said average voltage value respectively falls outside one of said plurality of threshold values; and
said voltage threshold event includes performing a data snapshot for said measurement period, said data snapshot comprising said average voltage value for said measurement period, a minimum voltage value *Vlow* for said measurement period, a maximum voltage value *Vhigh* for said measurement period, and the date and time of occurrence of said voltage threshold event.

18. The system of claim 10, wherein:

said utility consumer meter is configured to trigger a voltage threshold event if said average voltage value respectively falls outside one of said plurality of threshold values;
said system includes a communications network;
said voltage threshold event comprises a data snapshot;
said second voltage threshold event comprises an alarm signal sent over said communications network to said voltage monitoring center; and
said communications network is an RF LAN communications network.

19. A method for monitoring voltage in an electrical power transmission infrastructure associated with a communications network, comprising:

establishing a plurality of threshold values *Vmax1, Vmin1, Vmax2,* and *Vmin2;*
performing a plurality of instantaneous voltage measurements *Vinst* at a utility consumer meter for a measurement period;
determining an average voltage value for the measurement period at the utility consumer meter from the plurality of instantaneous voltage measurements;
determining a minimum voltage value *Vlow* by

setting an initial value of *Vlow* to a nominal voltage value; comparing each instantaneous voltage measurement *Vinst* to *Vlow,* and setting *Vlow* equal to the instantaneous voltage measurement *Vinst* if the instantaneous voltage measurement *Vinst* is less than *Vlow*;

determining a maximum voltage value *Vhigh* by setting an initial value of *Vhigh* to the nominal voltage value, comparing each such instantaneous voltage measurement *Vinst* to *Vhigh,* and setting *Vhigh* equal to the instantaneous voltage measurement *Vinst* if the instantaneous voltage measurement *Vinst* is greater than *Vhigh;*

at the end of the measurement period, comparing the average voltage value respectively to each of the plurality of threshold values;

triggering a first threshold event if the average voltage value is greater than *Vmax1* or less than *Vmin1,* such triggering of such first threshold event including logging an event in a history log stored at an associated utility consumer meter; and

triggering a second threshold event if the average voltage value is greater than *Vmax2* or less than *Vmin2,* such triggering of such second threshold event including sending an exception alarm over the communications network.

20. The method of claim 19, wherein the method comprises; performing an instantaneous voltage measurement *Vinst* every second;

converting each instantaneous voltage measurement *Vinst* into an energy equivalent value Vh according to the following:

$$Vh = \frac{Vinst}{3600};$$

determining the average voltage value *Vdemand* according to the following:

$$Vdemand= \frac{\sum_{n=1}^{I} Vh_{(n)}}{I},$$ wherein *I* is equal to the number of seconds in said measurement period;

monitoring voltage quality at a substation meter located upstream of the utility consumer meter to generate voltage quality data for the associated electrical power transmission infrastructure; and

correlating said first voltage threshold event of the utility consumer meter with the voltage quality data for the associated electrical power transmission infrastructure;

wherein the communications network comprises an RF LAN communications network.

FIG. 1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6954814 B
- US 6792364 B, Jonker
- US 6675071 B
- US 6429785 B, Griffin
- US 20030009401 A, Ellis
- US 20020077729 A, Anderson
- US 20050132115 A, Leach
- US 6778920 B, Balch